# EUROPEAN PATENT APPLICATION

(11) **EP 4 693 753 A1**
(43) Date of publication of application: **11.02.2026**
(21) Application number: 25187739.5
(22) Date of filing: 07.07.2025
(51) Int. Cl.: H01R 12/72, H01R 12/73, H05K 1/14, H05K 3/36, H05K 1/18, H05K 1/11, H05K 1/02

(54) **CONDUCTIVE MEMORY MODULE NOTCH AND CONNECTOR-TO-MOTHERBOARD PINS FOR POWER OR GROUND**

(30) Priority: 07.08.2024 US 202418797211
(71) Applicant: INTEL Corporation, Santa Clara, CA 95054 (US)
(72) Inventor: HANKS, Landon, Milwaukie (US); HEYMANN, Douglas, Portland (US); LI, Xiang, Portland (US); HERNANDEZ VAZQUEZ, Ariadna, Tlaquepaque (MX)
(74) Representative: Rummler, Felix

(57) **Abstract**

Apparatus and methods for conductive memory module notch and connector-to-motherboard pins for power or ground. A memory module includes a conductive notch that is coupled to either one or more ground planes in respective layers in the memory module's PCB or to a power rail formed on one or more layers in the PCB. A memory module connector includes a notch pin that is configured to mate with the conductive notch when the memory module is installed in the connector. The connector is mounted to a motherboard or the like and the notch pin is coupled to either power (e.g., Vin) or ground in the motherboard. When coupled to power, Vin is supplied to the memory module via the notch pin/conductive notch. When coupled to ground on the motherboard, at least a portion of the ground planes in the PCB are coupled to ground via the notch pin/conductive notch.

## Description

### BACKGROUND INFORMATION

Double Data Rate (DDR) memory is an important element of a compute system that provides the compute applications a place to store and access data quickly. As input/output (I/O) bandwidths for DDR memory and other types of memory continue to increase, the margins for signal integrity become slimmer.

Conventional DDR DIMMS (Dual In-line Memory Modules) include a two-sided edge connector with asymmetric sets of contact pins and a notch or key that is used to orient the DIMM in the correct configuration such that the DIMM cannot be installed backwards. The DDR DIMMs are physically secured in a DIMM connector at the left and right hand ends of the DIMM using mechanical latches provided by the DIMM connector.

### BRIEF DESCRIPTION OF THE DRAWINGS

The foregoing aspects and many of the attendant advantages of this invention will become more readily appreciated as the same becomes better understood by reference to the following detailed description, when taken in conjunction with the accompanying drawings, wherein like reference numerals refer to like parts throughout the various views unless otherwise specified:
Figures 1a and 1b respectively show front side and backside views of a conventional 288-pin DDR5 DIMM;
Figures 2a and 2b respectively show front side and backside views including a power routing sublayer to a PMIC in the conventional 288-pin DDR5 DIMM;
Figures 3a and 3b respectively show front side and backside views of a an augmented 288-pin DDR5 DIMM having a conductive notch, according to one embodiment;
Figures 4a and 4b respectively show front side and backside views including a power routing sublayer to a PMIC in the augmented 288-pin DDR5 DIMM, according to one embodiment;
Figures 5a and 5b show a comparison between the DIMM and DIMM connector structures of DIMMs employing a conventional notch used for alignment/orientation and a conductive notch, according to one embodiment;
Figure 6a shows an elevation view illustrating selective details of a notch pin inserted into a conductive notch and four connector pins interfacing with four contact pins on a DIMM PCB, according to one embodiment;
Figures 6b, 6c, and 6d show further details of the notch pin and conductive notch of the embodiment shown in Figure 6a;
Figures 7a and 7b illustrate an alternative two-piece structure that may be implemented as a notch pin, according to one embodiment;
Figures 8a and 8b show 3D views of an apparatus including a DIMM installed in a DIMM connector on a motherboard in which the notch pin and conductive notch are used to provide a ground return path between the ground planes in the DIMM and the motherboard, according to one embodiment;
Figures 9a shows 3D views of an apparatus including a DIMM installed in a DIMM connector on a motherboard in which the notch pin and conductive notch are used to connect power comprising an input voltage Vin supplied by the motherboard to power rail circuitry in the DIMM, and further wherein ground planes in front of a power plane are removed, according to one embodiment;
Figure 9b shows a cutaway cross section 3D view of the DIMM of Figure 9a;
Figure 9c shows a 3D view of the DIMM of Figure 9a with all the ground planes included;
Figure 9d shows a zoomed-in 3D view of the apparatus of Figures 9a showing further details of the conductive notch and the notch pin; and
Figure 10 shows a table and a graph demonstrating simulated IR drop performance of one embodiment of a DIMM model with a conductive notch when power is provided to the DIMM via the notch pin.

### DETAILED DESCRIPTION

Embodiments of apparatus and methods for conductive memory module notch and connector-to-motherboard pins for power or ground are described herein. In the following description, numerous specific details are set forth to provide a thorough understanding of embodiments of the invention. One skilled in the relevant art will recognize, however, that the invention can be practiced without one or more of the specific details, or with other methods, components, materials, *etc.* In other instances, well-known structures, materials, or operations are not shown or described in detail to avoid obscuring aspects of the invention.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

For clarity, individual components in the Figures herein may also be referred to by their labels in the Figures, rather than by a particular reference number. Additionally, reference numbers referring to a particular type of component (as opposed to a particular component) may be shown with a reference number followed by "(typ)" meaning "typical." It will be understood that the configuration of these components will be typical of similar components that may exist but are not shown in the drawing Figures for simplicity and clarity or otherwise similar components that are not labeled with separate reference numbers. Conversely, "(typ)" is not to be construed as meaning the component, element, *etc.* is typically used for its disclosed function, implement, purpose, *etc.*

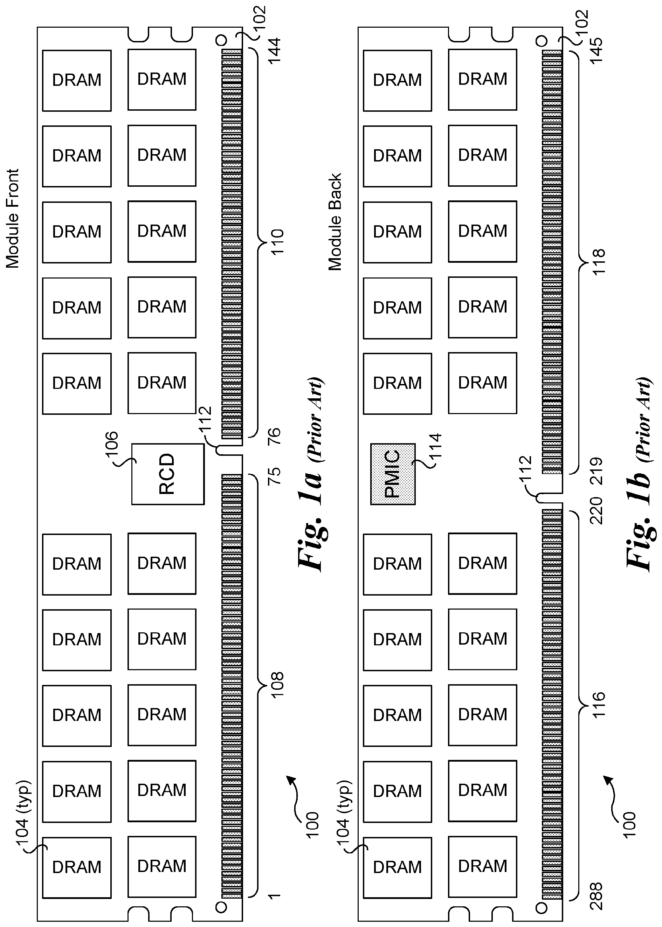

Figures 1a and 1b respectively show simplified front-side and backside views of a conventional 288-pin DDR5 (Double Data Rate 5^{th} generation) Dual In-line Memory Module (DIMM) 100, focusing on the connector structure. The physical form factor for DIMM 100 is specified in JEDEC Standard PS-005, October 2022. DIMM 100 comprises a printed circuit board (PCB) 102 on which multiple DRAM chips 104 are mounted (on both sides). The number and arrangement of the DRAM chips in the figures herein is exemplary and non-limiting, as will be recognized by those skilled in the art. Under the JEDEC DDR5 Standard the number of DRAM chips and arrangement is left up to the manufacturer. DIMM 100 also includes a Registering Clock Driver (RCD) chip 106 on the front side and a PMIC (Power Management Integrated Circuit) 114 on the backside.

For illustrative and descriptive purposes herein, the connector structure is split into four sets of pins (also referred to as contact pins). On the front side the sets of pins include frontside lefthand pins 108 and frontside righthand pins 110. Under the 288-pin DDR5 connector structure, frontside lefthand pins 108 comprises 75 pins, while frontside righthand pins 110 comprises 69 pins. The frontside pins are numbered 1 to 144 moving from left to right. The backside pins include backside lefthand pins 116 comprising 69 pins and backside righthand pins 118 comprising 75 pins. The backside pins are numbered 145 to 288 moving from right to left. The DIMM's form factor also includes a notch or key 112. The asymmetry of the sets of pins and the notch/key is so the DIMM cannot be installed backwards. This approach is commonly used for other types of memory devices, including but not limited to DIMMs (e.g., Small Outline DIMMs (SODIMMs) and microDIMMs).

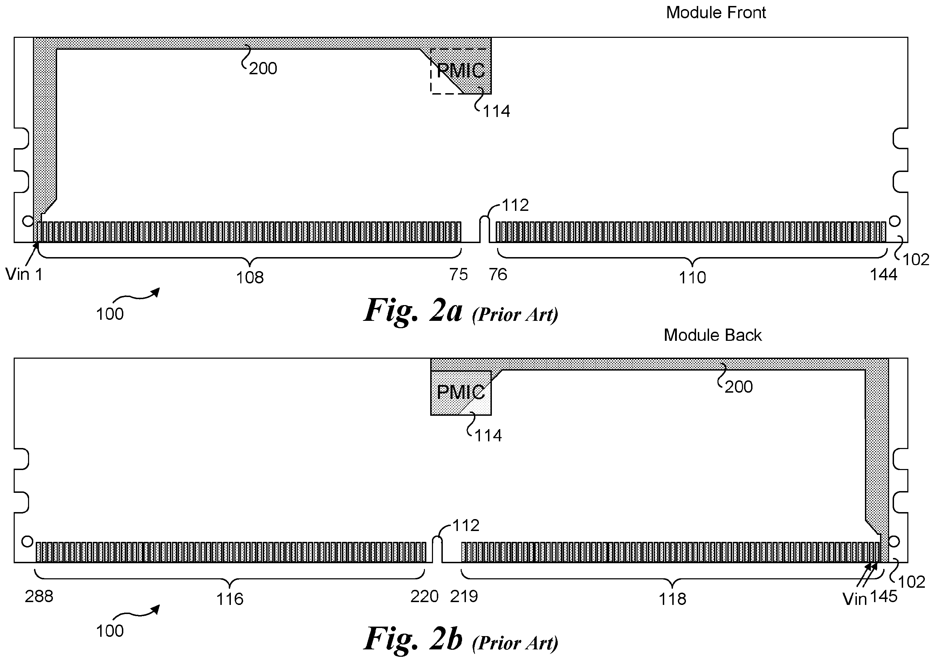

Figures 2a and 2b show how power is routed to PMIC 114 using DIMM 100. A voltage Vin is provided via a mating connector to pins 1, 145, and 146. These pins are electrically coupled to a power rail 200 having the sub-layer routing shown. Generally, the power rail may comprise sub-layer routing in one or more layers in the DIMM PCB, as is known in the art.

Interconnects are integral components in the chain of data transfer and receipt as are the respective memory module endpoints connecting to them. As shown in Figures 2a and 2b, the voltage rails from the motherboard to the memory module are typically on one side of the connector and memory module where the voltage supplied components are centrally located on the module.

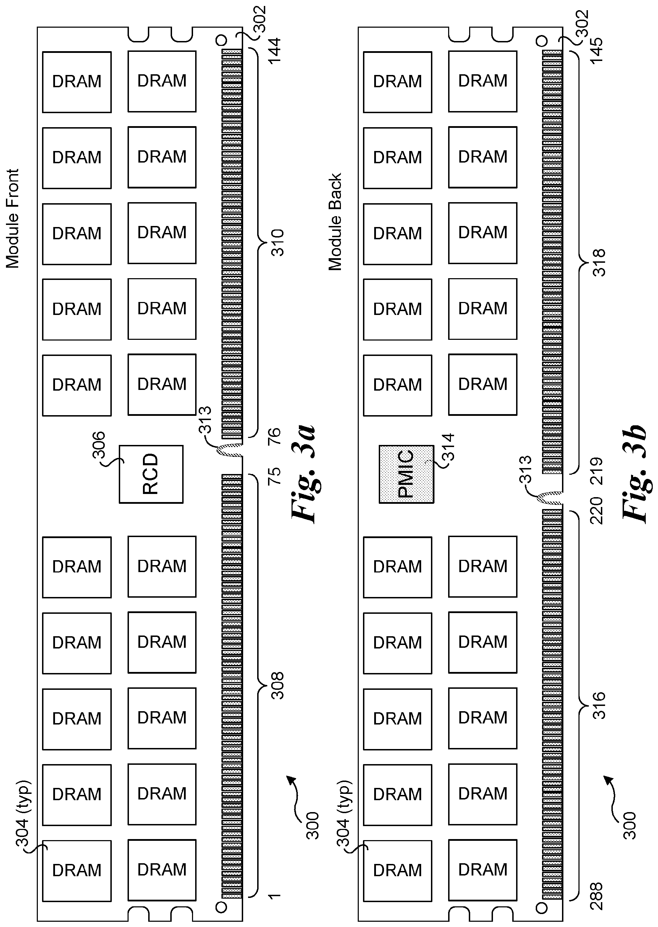

Figures 3a and 3b respectively show simplified front-side and backside views of an augmented 288-pin DDR5 DIMM 300 with a conductive notch, according to one embodiment. DIMM 300 includes a PCB 302 with multiple DRAM chips 304 installed on both sides, and RCD chip 306 installed on the front side, and a PMIC 314 installed on the backside. Like before, the connector pins are split into four sets including 75 frontside lefthand pins 308, 69 frontside righthand pins 310, 69 backside lefthand pins 316 and 75 backside righthand pins 318.

In one aspect, the structure (configuration, number of pins, shape of pins) in DIMM 300 is the same as for DIMM 100 (both compliant with the physical form factor of the connector as applied to the pins/contact pins. However, under DIMM 300 the conventional notch/key 112 has been replaced with a conductive notch 313 (alternatively referred to as a conductive key). Conductive notch 313 is configured to mate with a notch pin that provides either Vin or is tied to ground (GND). Further details of conductive notches/keys and mating notch pins are described and illustrated below.

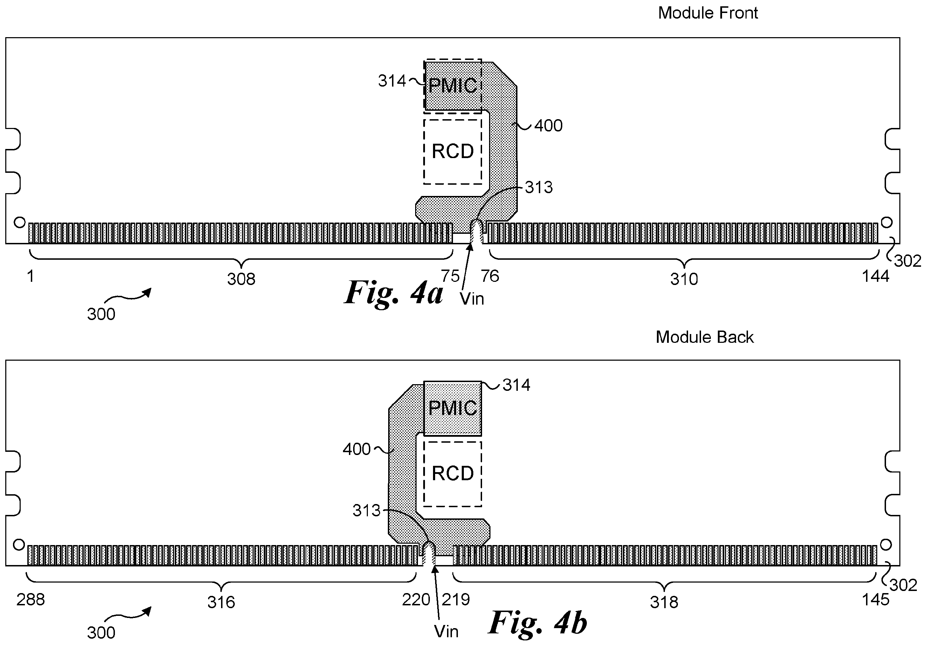

Figures 4a and 4b show how power is routed to PMIC 314 using DIMM 300, according to one embodiment. A power rail 400 comprising sub-layer routing on one or more layers in PCB 302 provides a significantly shorter path than power rail 200 under the conventional DIMM 100.

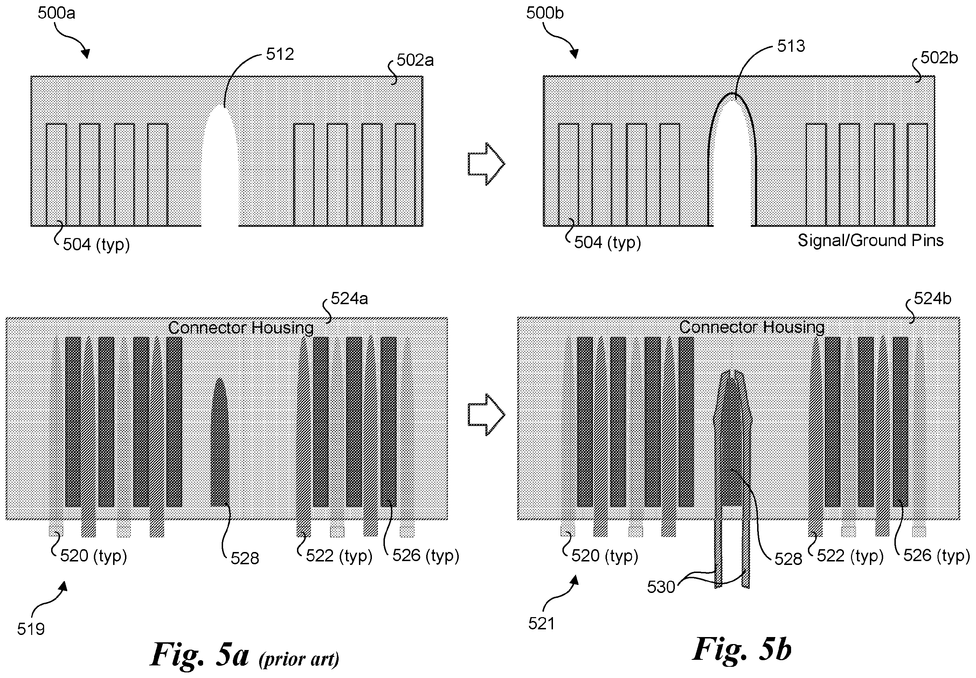

Figures 5a and 5b show further details of the conventional DIMM connector housing and the augmented connector housing in accordance with some embodiments. A conventional DIMM 500a includes a PCB 502a having front and back surfaces over which a plurality of gold fingers 504 are formed. The gold fingers, which is the terminology used in JEDEC Standard PS-005, are also referred to in the industry as contact pins, contact pads, or pins. Conventional DIMM 500a includes a notch 512. DIMM 500b has a similar structure including a PCB 502b and a plurality of gold fingers 504. However, rather than a notch 512, DIMM 500b includes a conductive notch 513.

The lower portions of Figures 5a and 5b show simplified representations of connectors 519 and 521, which would be mounted to a motherboard, mainboard, base board, or similar - for convenience the term "motherboard" is used in the remaining portion of this specification, while those of skill in the art will recognize motherboard is non-limiting and is representative of various types of boards to which memory module connectors are mounted. Connector 519 includes a plurality of signal pins 520 and ground pins 522 disposed in a connector housing 524a. A plurality of pin isolation walls 526 are disposed between pairs of signal and ground pins. Connector 519 further includes a connector center bump 528.

Connector 521 has a similar configuration including a plurality of signal pins 520 and ground pins 522 disposed in a connector housing 524b having pin isolation walls 526. Connector 521 further includes conductive notch pins 530 or a conductive bar, or otherwise a conductive member that functions as a notch pin, as described and illustrated in the embodiments below. When DIMM 500b is inserted into connector 521, the conductive notch pins 530 are in contact with the sidewalls of conductive notch 513.

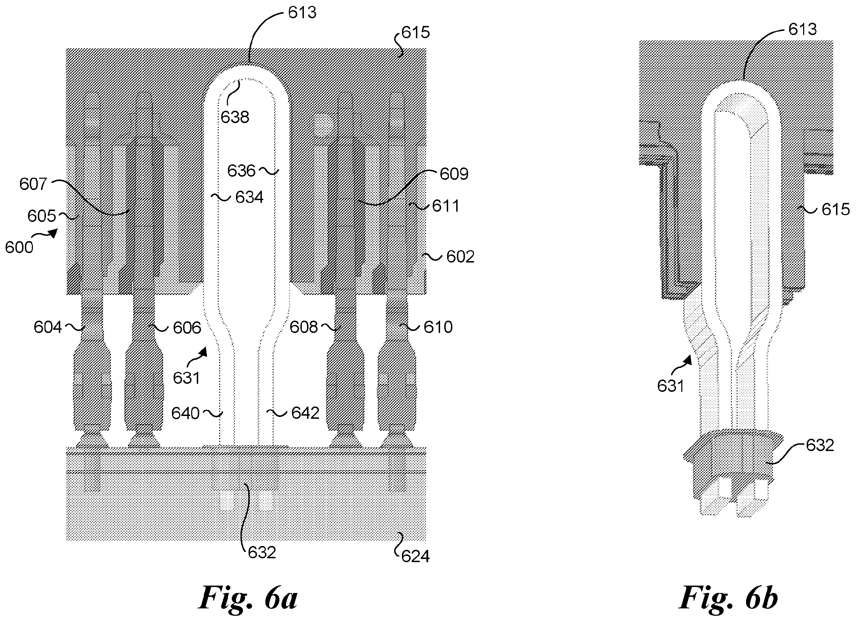

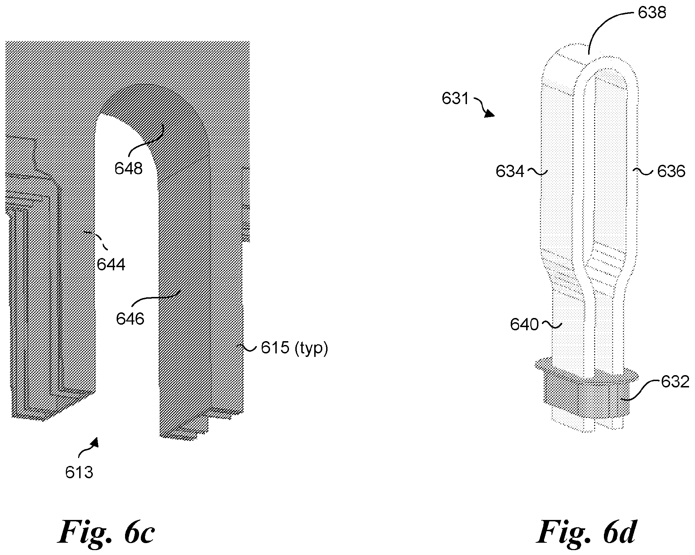

Figures 6a-6d show further details of structures of the conductive notches and notch pins, according to some embodiments. In this example, the notch pin and conductive notch are configured to provide a ground patch to a DIMM 600. In Figure 6a a portion of DIMM 600 is shown, which includes a PCB 602 having contact pins 605, 607, 609, and 611, where contact pins 605 and 609 are ground pins that are electrically coupled (internally using vias in PCB 602 to one or more ground planes 615. The connector includes ground pins 604 and 610 and signal pins 606 and 608, which are disposed within a connector housing (not separately shown) and which are mounted to a motherboard 624.

A notch pin 631 includes a collar or anchor 632 that is installed in motherboard 624. Alternatively, a similar collar or anchor or the like could be fixedly coupled to the connector housing. In the illustrated embodiment notch pin 631 comprises a wrap-around bar that is configured to have a compression fit within conductive notch 613 and includes a pair of parallel sides or tabs 634 and 636 coupled to an arch 638. The lower portion of notch pin 631 includes legs 640 and 642 that pass through slots in collar/anchor 632.

Figure 6c shows further details of conductive notch 613 formed in PCB 602. The conductive notch includes a pair of parallel sidewalls 644 and 646 coupled to an arch 648. A conductive material (e.g., gold or copper) is formed over a notch in the PCB 602 during manufacture of the PCB, such as via plating or a deposition operation. The conductive notch is further connected to multiple ground planes 615 in respective layers in PCB 602.

When notch pin 631 is inserted into conductive notch 613 the sides or tabs 634 and 636 slide against respective sidewalls 644 and 646, which causes a slight compression or deformation of the upper portion of notch pin 631, resulting in a compression fit. The compression fit serves two functions. First, it provides an electrical path between sides or tabs 634 and 636 and sidewalls 644 and 646, which is the primary function. Second, the conductive notch/notch pin provides enhanced stability of the DIMM within the DIMM connector when compared with the conventional approach under with the center bump is used to ensure the DIMM is not installed backwards, but otherwise is not in contact with the sidewalls of the notch.

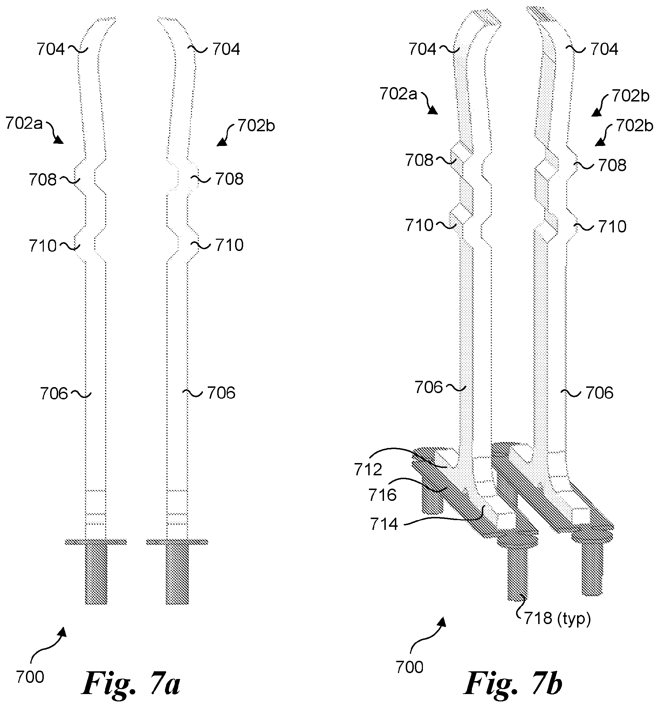

Figures 7a and 7b show views of a two-piece notch pin 700, according to one embodiment. Each of structures 702a and 702b have a similar shape including an arced upper portion 704, legs 706, and bump outs 708 and 710. Each leg 706 includes a pair of feet 712 and 714 extending in opposite directions at the base of the leg, as shown in Figure 7b. Structures 702a and 702b may also include an SMT mounting structure 716 including a pair of extensions 718 that are coupled to respective SMT solder bumps on the motherboard when structures 702a and 702b are mounted to the motherboard (noting structure 702a and 702b would be physically coupled within the DIMM connector housing and SMT mounting structure 716 would be exposed on the underside of the connector housing).

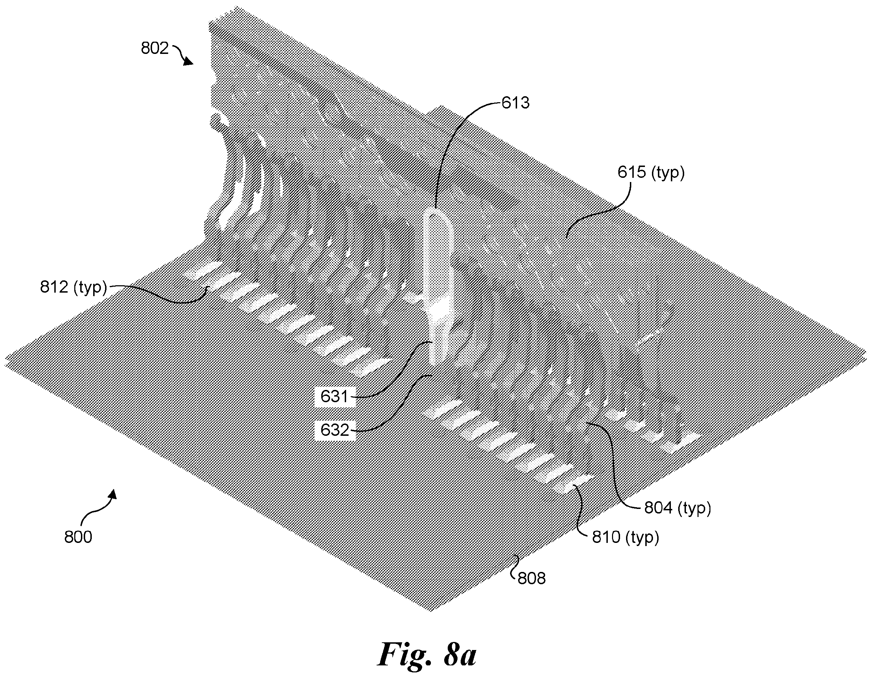

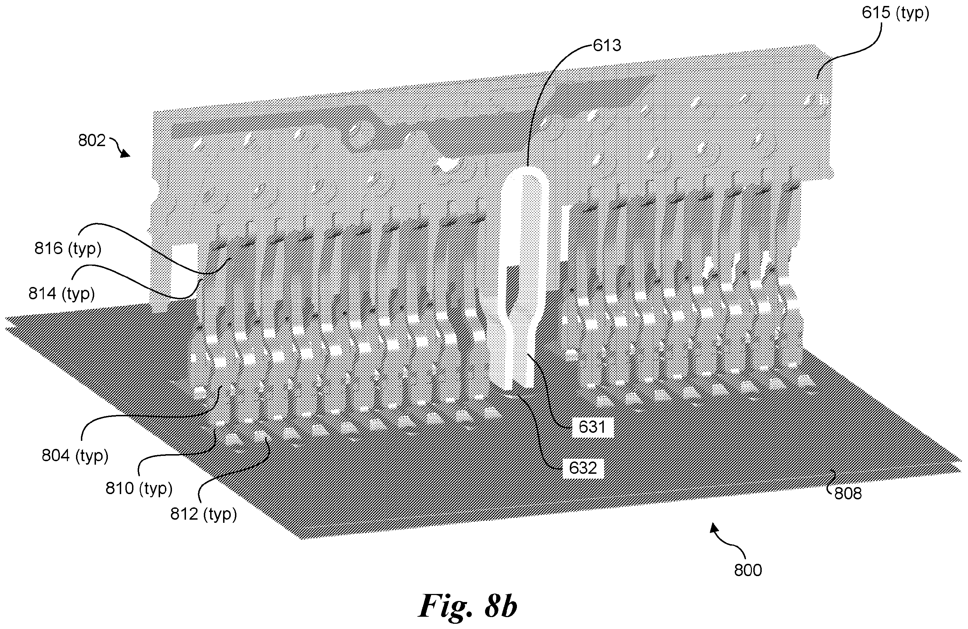

Figures 8a and 8b show 3D views of an apparatus 800 including a DIMM 802 that is installed in a DIMM connector mounted to a motherboard 808. A DIMM 802 is illustrated showing multiple ground planes formed in respective layers of the DIMMs PCB, with other layers including isolation layers and signal routing layers removed for clarity. The PBM in DIMM 802 includes a conductive notch 613 similar to that shown in Figure 6c. Notch pin 631 is inserted into notch 613 when DIMM 802 is inserted into the DIMM connector.

In some of the Figures herein including Figures 8a and 8b the DIMM connector housing is not shown so as to not obscure the internal components of the DIMM connector. Those components include sets of pins 804, including pins used for data signals, ground, and power (e.g., Vin). In some embodiments, the ground pins include a foot structure 810 that is coupled to a respective surface mount technology (SMT) solder bumps formed on the surface of motherboard 808 while the signal pins include a foot 812 that is mounted to a respective SMT pad or solder bump. As further shown in Figure 8b, the upper portion of each ground pin is in contact with a ground contact pin 814 on the DIMM PCB edge connector, while the upper portion of each signal pin is in contact with a signal contact pin 816 on the DIMM PCB edge connector.

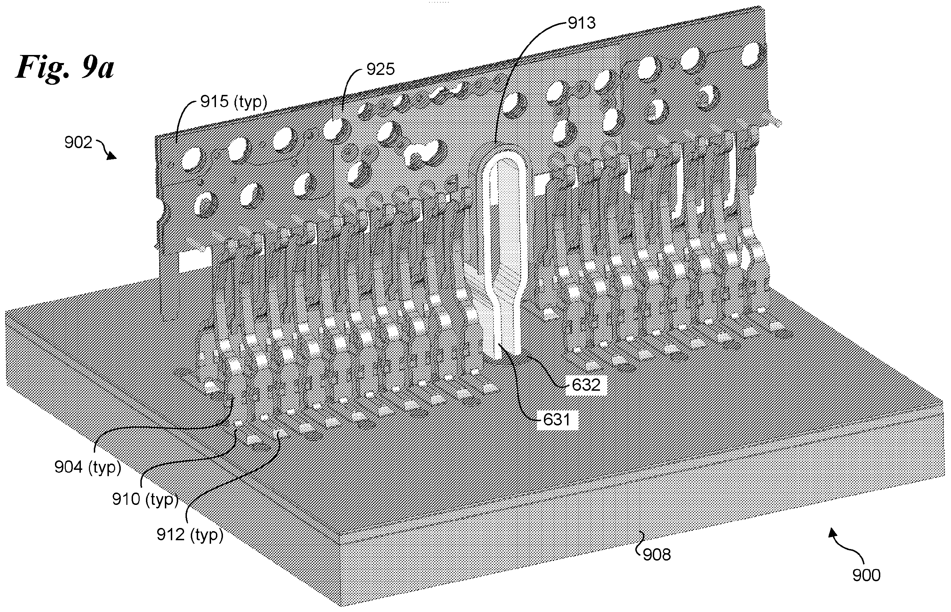

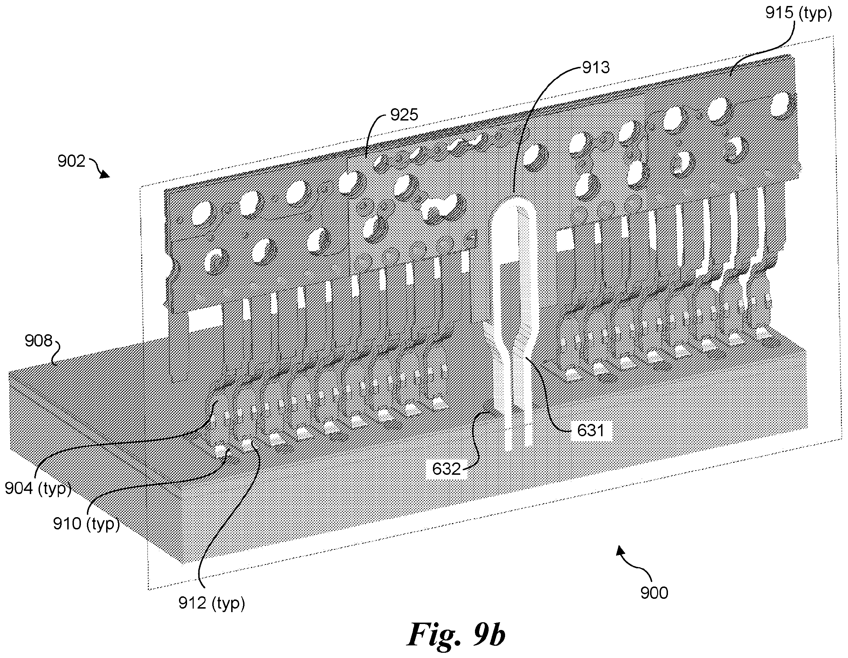

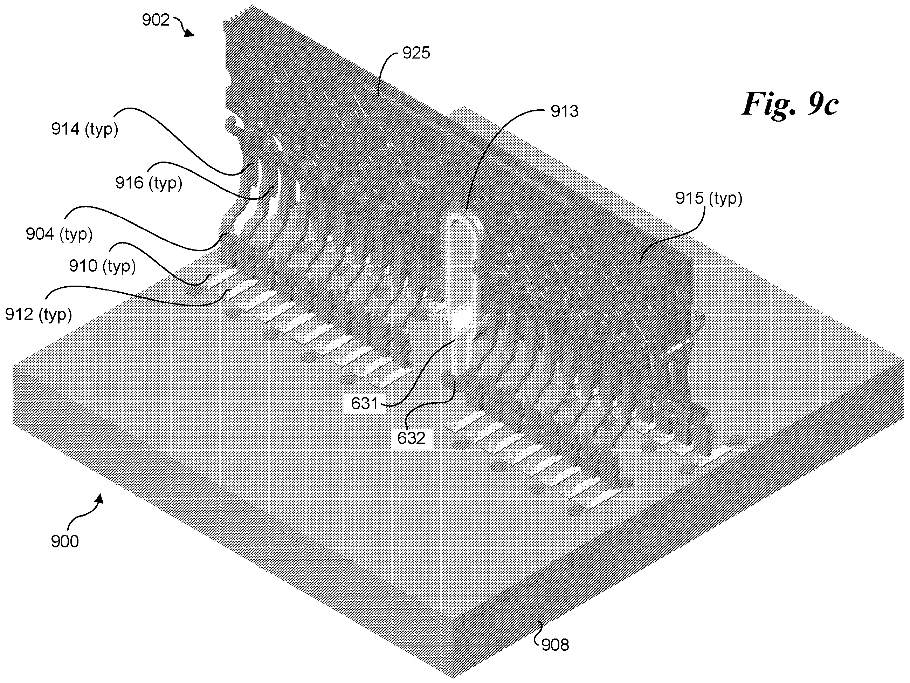

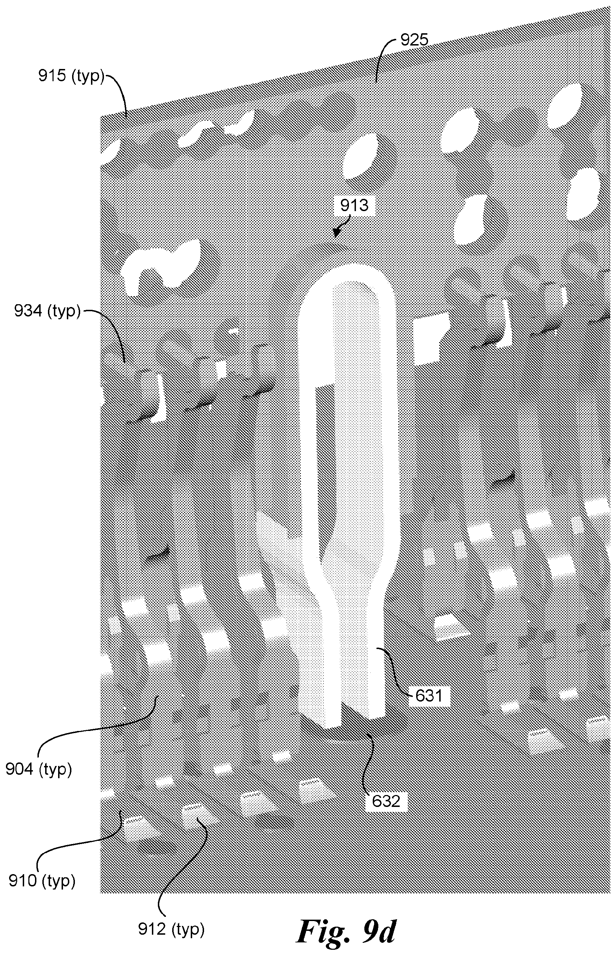

Figures 9a-9d show views of an apparatus 900 under which notch pin 631 is used to supply power to a DIMM 902. In Figures 9a, 9b, and 9d, the ground plane layers 915 in front of a power plane layer 925 are removed for clarity, while Figure 9c shows all the ground plane layers. Under this embodiment, the sidewalls and arch of conductive notch 913 are electrically coupled to traces in power plane layer 925. Meanwhile, there is a small gap between the arch and upper portions of the sidewalls of conductive notch 913 and the ground plane structures in ground plane layers 915 such that there is no coupling of power to the ground planes in DIMM 902.

The DIMM connector structure of apparatus 900 is like the DIMM connector structure of apparatus 800. As before, the connector housing is not shown. The DIMM connector components include sets of pins 904, including pins used for data signals and ground; however, under one embodiment the connector pins 1, 145, and 146 used to provide power (Vin) under the conventional 288-pin DDR5 DIMM are not connected to Vin and are left floating. The ground pins include a foot structure 910 that is coupled (e.g., via solder) to an SMT pad formed on the surface of motherboard 908 while the signal pins include a foot 912 that is mounted to a respective SMT pad. As further shown in Figure 9c, the upper portion of each ground pin is in contact with a ground contact pin 914 on the DIMM PCB edge connector, while the upper portion of each signal pin is in contact with a signal contact pin 916 on the DIMM PCB edge connector. As shown in Figure 9d, vias 934 formed in the DIMM PCB are used to couple ground and data signals from respective ground and signal pins to ground in ground plane layers 915 and signal routing planes (not shown) in the DIMM PCB.

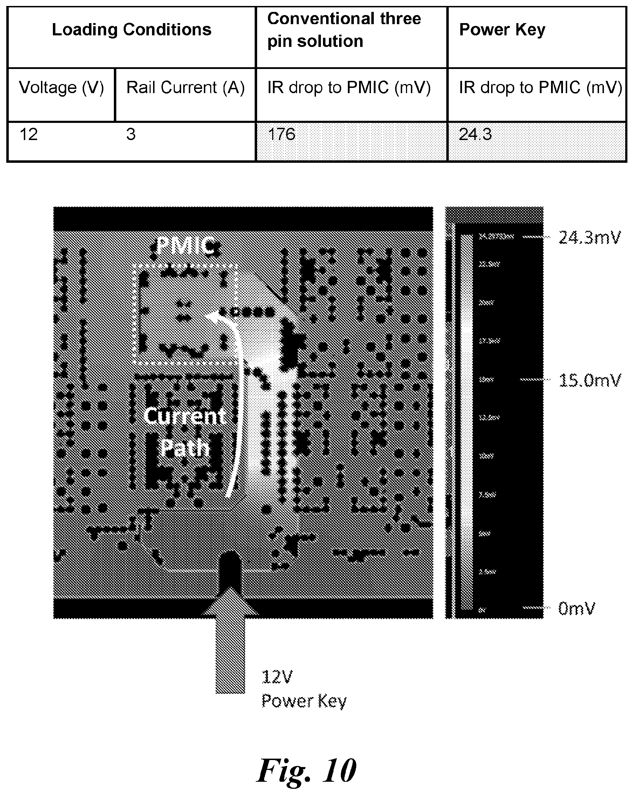

Figure 10 shows IR drop performance of one embodiment of a DIMM with a conductive notch when power is provided to the DIMM via the notch pin. The performance results were simulated using CADENCE^{™} Sigrity POWERDC^{™} and applied to a DIMM model having a power rail configuration shown in Figure 10 that is similar to power rail 400 in Figure 4. As shown in the table at the top of Figure 4, the IR drop to the PMIC is 24.3mV, which is a 7x improvement over the IR drop to the PMIC (176mV) using the conventional 3-pin solution employed by a 288-pin DDR5 DIMM provided by one manufacturer.

Utilization of the conductive notch with mating notch pin provides several advantages over conventional DIMMs. When used to provide power to the DIMM, the routing path of the power rail is substantially reduced, resulting in lower IR drop, as shown in Figure 10. When used as a ground, the ground return path for the memory module and motherboard is increased. The compression fit aspect provides an additional anchor point in the center of the connector for enhanced mechanical stability.

Although some embodiments have been described in reference to particular implementations, other implementations are possible according to some embodiments. Additionally, the arrangement and/or order of elements or other features illustrated in the drawings and/or described herein need not be arranged in the particular way illustrated and described. Many other arrangements are possible according to some embodiments.

In each system shown in a figure, the elements in some cases may each have a same reference number or a different reference number to suggest that the elements represented could be different and/or similar. However, an element may be flexible enough to have different implementations and work with some or all of the systems shown or described herein. The various elements shown in the figures may be the same or different. Which one is referred to as a first element and which is called a second element is arbitrary.

In the description and claims, the terms "coupled" and "connected," along with their derivatives, may be used. It should be understood that these terms are not intended as synonyms for each other. Rather, in particular embodiments, "connected" may be used to indicate that two or more elements are in direct physical or electrical contact with each other. "Coupled" may mean that two or more elements are in direct physical or electrical contact. However, "coupled" may also mean that two or more elements are not in direct contact with each other, but yet still co-operate or interact with each other. Additionally, "communicatively coupled" means that two or more elements that may or may not be in direct contact with each other, are enabled to communicate with each other. For example, if component A is connected to component B, which in turn is connected to component C, component A may be communicatively coupled to component C using component B as an intermediary component.

An embodiment is an implementation or example of the inventions. Reference in the specification to "an embodiment," "one embodiment," "some embodiments," or "other embodiments" means that a particular feature, structure, or characteristic described in connection with the embodiments is included in at least some embodiments, but not necessarily all embodiments, of the inventions. The various appearances "an embodiment," "one embodiment," or "some embodiments" are not necessarily all referring to the same embodiments.

Not all components, features, structures, characteristics, *etc.* described and illustrated herein need be included in a particular embodiment or embodiments. If the specification states a component, feature, structure, or characteristic "may", "might", "can" or "could" be included, for example, that particular component, feature, structure, or characteristic is not required to be included. If the specification or claim refers to "a" or "an" element, that does not mean there is only one of the element. If the specification or claims refer to "an additional" element, that does not preclude there being more than one of the additional element.

As used herein, a list of items joined by the term "at least one of" can mean any combination of the listed terms. For example, the phrase "at least one of A, B or C" can mean A; B; C; A and B; A and C; B and C; or A, B and C.

The above description of illustrated embodiments of the invention, including what is described in the Abstract, is not intended to be exhaustive or to limit the invention to the precise forms disclosed. While specific embodiments of, and examples for, the invention are described herein for illustrative purposes, various equivalent modifications are possible within the scope of the invention, as those skilled in the relevant art will recognize.

These modifications can be made to the invention in light of the above detailed description. The terms used in the following claims should not be construed to limit the invention to the specific embodiments disclosed in the specification and the drawings. Rather, the scope of the invention is to be determined entirely by the following claims, which are to be construed in accordance with established doctrines of claim interpretation.

## Claims

1. A memory module, comprising:
a printed circuit board (PCB) having a plurality of layers configured to route ground, power, and data signals, the PCB having a front side and a back side;
a two-sided edge connector comprising a plurality of contact pins on the front side and the back side of the PCB;
a plurality of memory devices, mounted to the front side and back side of the PCB;
power management circuitry, mounted to the PCB;
a conductive notch formed in the PCB;
a plurality of ground planes formed in respective layers of the PCB; and
a power rail formed in one or more sub-routing layers of the PCB coupled to the power management circuitry,
wherein one of,
at least a portion of the plurality of the ground planes; or
the power rail
is electrically coupled to the conductive notch.

2. The memory module of claim 1, wherein the conductive notch and the power management circuitry are disposed toward the center of the PCB.

3. The memory module of claim 2, wherein the power management circuitry includes a power management integrated circuit (PMIC).

4. The memory module of claim 2 or 3, further comprising a registering clock driver (RCD) chip, mounted on a first side of the PCB comprising one of the front side and back side of the PCB and disposed toward the center of the PCB,
wherein the power management circuitry is mounted on a second side of the PCB opposite the side the RCD chip is mounted on, and wherein the one or more sub-routing layers of the PCB for the power rail includes conductive traces coupled to the conductive notch that are routed around a footprint of the RCD chip.

5. The memory module of any of the preceding claims, wherein the conductive notch comprises parallel sidewalls connected to a top portion, and wherein a conductive material is formed over at least the parallel sides.

6. The memory module of any of the preceding claims, wherein the memory module comprises a Dual In-line Memory Module (DIMM) with asymmetrical sets of pins and wherein the conductive notch operates as a key.

7. A memory module connector, comprising:
a connector housing in which components are disposed including,
a plurality of pins, arranged in parallel rows and configured to electrically couple to mating contact pins on a two-sided edge connector of a memory module, the memory module having a conductive notch, each of the plurality of pins including a foot disposed below the connector housing; and
a notch pin, configured to engage one or more conductive surfaces on the conductive notch when the memory module is installed in the memory module connector.

8. The memory module connector of claim 7, wherein the notch pin comprises a metallic structure having a pair of parallel sides coupled to an arcuate top portion, wherein each parallel side is coupled to a respective leg.

9. The memory module connector of claim 8, further comprising a collar having a pair of slots through which the respective legs pass.

10. The memory module connector of claim 8 or 9, wherein each leg includes a respective foot.

11. The memory module connector of any of claims 7-10, wherein the notch pin comprises a pair of metallic structures having a mirrored configuration, each metallic structure including an upper portion arcing inward coupled to a leg extending downward.

12. The memory module connector of claim 11, wherein each leg is coupled to a pair of feet extending perpendicular to the leg in opposite directions.

13. A method comprising:
coupling, via a conductive notch formed in a Dual In-line Memory Module (DIMM), an input voltage (Vin) used to supply power to the DIMM or ground (GND), where Vin or GND is coupled via a notch pin extending upward from a DIMM connector that is in electrical contact with one or more surfaces of the conductive notch when the DIMM is installed in the DIMM connector.

14. The method of claim 13, wherein the DIMM comprises an augmented 288-pin Double Data Rate 5^{th} Generation (DDR5) Dual In-line Memory Module (DIMM), and the conductive notch replaces a notch or key on a conventional 288-pin DDRS DIMM.

15. The method of claim 13 or 14, wherein the notch pin is configured to be deformed when installed in the conductive notch to facilitate a compression fit.
